# FASCICULE DE BREVET EUROPEEN

(11) **EP 4 099 100 B1**
(45) Date de publication et mention de la délivrance du brevet: **12.03.2025**
(21) Numéro de dépôt: 22171187.2
(22) Date de dépôt: 02.05.2022
(51) Int. Cl.: G04B 17/06, G04B 17/20, G04C 3/04

(54) **MOUVEMENT HORLOGER MUNI D'UN OSCILLATEUR COMPRENANT UN SPIRAL PIEZOELECTRIQUE**
UHRWERK, DAS MIT EINEM OSZILLATOR AUSGESTATTET IST, DER EINE PIEZOELEKTRISCHE SPIRALE ENTHÄLT
TIMEPIECE MOVEMENT PROVIDED WITH AN OSCILLATOR COMPRISING A PIEZOELECTRIC HAIRSPRING

(30) Priorité: 02.06.2021 EP 21177468
(43) Date de publication de la demande: 07.12.2022
(73) Titulaire: The Swatch Group Research and Development Ltd, 2074 Marin (CH)
(72) Inventeur: IMBODEN, Matthias, 2072 St-Blaise (CH); HAEMMERLI, Alexandre, 2000 Neuchâtel (CH); DIDIER, Alexandre, 3235 Erlach (CH); NICOLAS, Cédric, 2000 Neuchâtel (CH)
(74) Mandataire: ICB SA

(56) Documents cités:
- EP-A1- 2 908 185
- EP-A1- 3 629 103
- US-A1- 2013 051 191

## Description

### Domaine technique de l'invention

La présente invention concerne un mouvement horloger comprenant un barillet et un affichage analogique de l'heure, qui est entraîné par le barillet via un rouage, ainsi qu'un balancier-spiral pour commander la marche du mouvement horloger. Le spiral est du type piézoélectrique avec des électrodes agencées sur des deux surfaces latérales.

### Arrière-plan technologique

On connaît du brevet US 9,721,169 un mouvement horloger comprenant un oscillateur du type balancier-spiral avec un spiral piézoélectrique muni d'électrodes reliées à une capacité variable pour pouvoir varier la rigidité du spiral et ainsi ajuster sa fréquence propre pour augmenter la précision de l'affichage de l'heure.

Les demandes de brevet EP 3 540 528 et EP 3 629 103 décrivent respectivement un procédé de régulation de la fréquence moyenne d'un balancier-spiral et un procédé de synchronisation de la fréquence d'un balancier-spiral en utilisant un spiral piézoélectrique relié à une unité électronique de commande munie d'un oscillateur à quartz. De même pour la demande US2013/051191, qui comprend en outre, une source d'énergie électrique pour alimenter l'unité électronique de commande et son circuit électronique.

### Résumé de l'invention

La présente invention a pour objectif de modifier un mouvement horloger du type mécanique de manière à augmenter sa réserve de marche et permettre d'améliorer sa précision de marche, sans pour autant renoncer à un balancier-spiral pour cadencer la marche du mouvement horloger, notamment l'entraînement de son dispositif d'affichage analogique.

A cet effet, la présente invention concerne un mouvement horloger comprenant un affichage analogique de l'heure, un rouage, un barillet entraînant l'affichage analogique via le rouage, et un oscillateur formé d'un résonateur, comprenant un balancier et un spiral piézoélectrique, et d'un échappement mécanique couplant le balancier au rouage, le spiral piézoélectrique étant formé au moins partiellement d'un matériau piézoélectrique et comprenant au moins deux électrodes dont au moins une électrode est reliée à un circuit électronique de commande. Le matériau piézoélectrique et lesdites au moins deux électrodes sont agencés de manière à permettre l'application, gérée par le circuit électronique de commande, d'une contrainte électrique sur le spiral piézoélectrique. Le circuit électronique de commande est agencé pour pouvoir être relié à une source d'énergie électrique et pouvoir gérer l'application, au moins par moments, d'une tension électrique d'alimentation à ladite au moins une électrode de manière à exciter électriquement l'oscillateur pour obtenir une oscillation fonctionnelle du résonateur et à ensuite entretenir cette oscillation fonctionnelle. De plus, l'échappement mécanique est configuré de sorte à être un échappement compteur des alternances de l'oscillation fonctionnelle, pour ainsi rythmer la marche du mouvement horloger, sans que le résonateur puisse recevoir du barillet via cet échappement une énergie mécanique suffisante à l'entretien d'une oscillation fonctionnelle. L'oscillateur selon l'invention est donc un oscillateur électromécanique ayant une alimentation électrique et un dispositif de comptage formé par un échappement mécanique.

Grâce aux caractéristiques de l'invention, l'affichage analogique de l'heure est entraîné par un barillet, c'est-à-dire par une source d'énergie mécanique propre à un mouvement mécanique, et sa marche est cadencée par un échappement mécanique associé à un résonateur du type balancier-spiral, alors que l'oscillateur électromécanique est alimenté indépendamment par une source d'énergie électrique permettant à un circuit électronique de commande de cet oscillateur électromécanique d'appliquer au moins par moments une tension électrique d'alimentation entre deux électrodes du spiral piézoélectrique, de sorte à activer et ensuite entretenir électriquement une oscillation du résonateur formant l'oscillateur électromécanique. L'oscillateur électromécanique est formé ainsi par un résonateur du type balancier-spiral ayant un spiral piézoélectrique. Dans un mode de réalisation préféré, cet oscillateur comprend un échappement mécanique qui est prévu uniquement compteur et l'oscillateur comprend ou est associé à un circuit électronique de commande qui est agencé pour gérer une alimentation électrique du spiral piézoélectrique de manière à entretenir seul le résonateur.

Dans le mode de réalisation préféré, l'oscillateur électromécanique est donc indépendant du barillet pour ce qui concerne la fourniture d'énergie, de sorte que le rouage peut être agencé pour optimiser sa consommation d'énergie mécanique tout en conservant un couple suffisant pour des indicateurs de l'affichage analogique de sorte à assurer un bon entraînement de ceux-ci. La réserve de marche, dans la mesure où l'énergie électrique est suffisante à l'entretien de l'oscillateur électromécanique, est par conséquent grandement augmentée.

Dans une variante avantageuse du mode de réalisation préféré, le circuit électronique de commande, qui gère seul l'alimentation électrique du spiral piézoélectrique, est agencé de manière à pouvoir réguler la tension d'alimentation de sorte à maintenir sensiblement constante l'amplitude de l'oscillation du résonateur. Ainsi l'isochronisme est amélioré et la précision du mouvement horloger est augmentée, ceci sans oscillateur électronique complémentaire.

### Brève description des figures

L'invention sera décrite ci-après de manière plus détaillée à l'aide des dessins annexés, donnés à titre d'exemples nullement limitatifs, dans lesquels :
- la Figure 1 est une vue en perspective d'un mode de réalisation d'un mouvement horloger selon l'invention (sans la masse oscillante prévue pour remonter le barillet) ;
- la Figure 2 est une vue de dessous du mouvement horloger de la Figure 1, duquel le pont de balancier et la raquetterie ont été enlevés ;
- la Figure 3 est une représentation schématique d'une montre selon l'invention incorporant un mouvement horloger selon l'invention ;
- la Figure 4 représente partiellement un mode de réalisation d'un échappement mécanique, dans divers états spécifiques, prévu pour former un oscillateur électromécanique incorporé dans le mode de réalisation du mouvement horloger de la Figure 1 ;
- la Figure 5 est une vue agrandie et schématique du résonateur formant l'oscillateur électromécanique incorporé dans le mode de réalisation du mouvement horloger de la Figure 1 ;
- la Figure 6 est coupe transversale du spiral piézoélectrique formant le résonateur de la Figure 5 ;
- la Figure 7 est une représentation schématique du circuit électronique de commande de l'oscillateur électromécanique incorporé dans le mode de réalisation du mouvement horloger de la Figure 1 ; et
- la Figure 8 est un graphe montrant le couple de force fourni à une roue des heures par un barillet classique incorporé dans un mouvement mécanique et le couple de force fourni à cette roue des heures par le même barillet incorporé dans le mouvement horloger de la Figure 1.

### Description détaillée de l'invention

En référence aux Figures on décrira un mode de réalisation d'un mouvement horloger selon l'invention, ainsi que l'agencement général d'une montre selon l'invention.

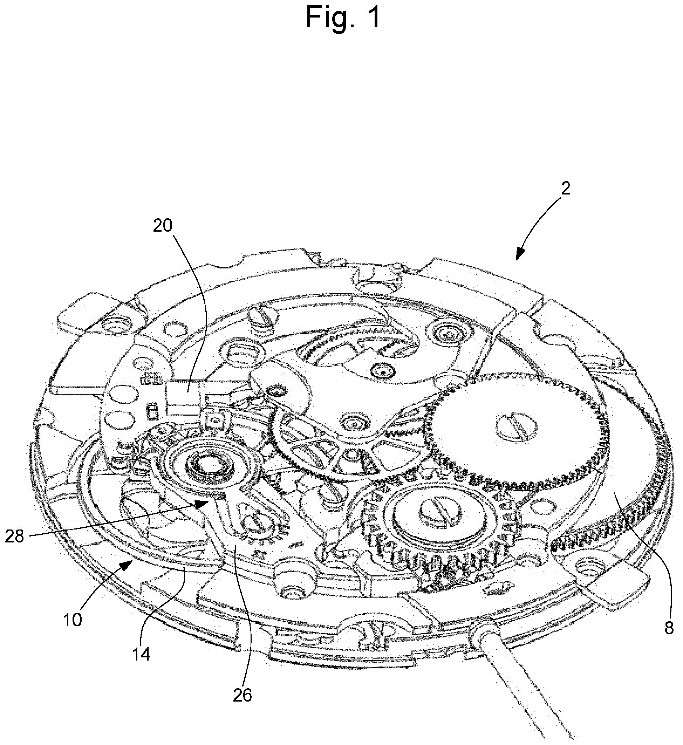

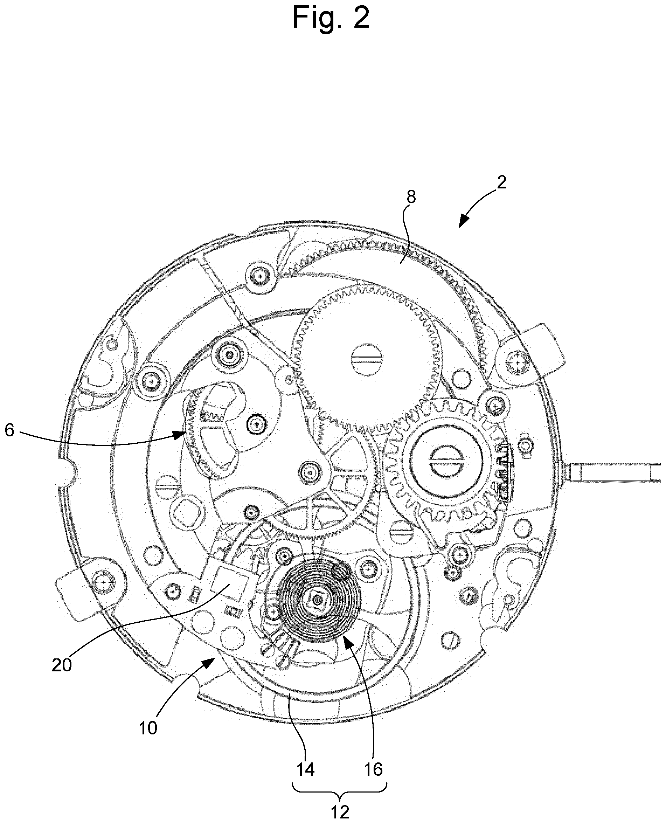

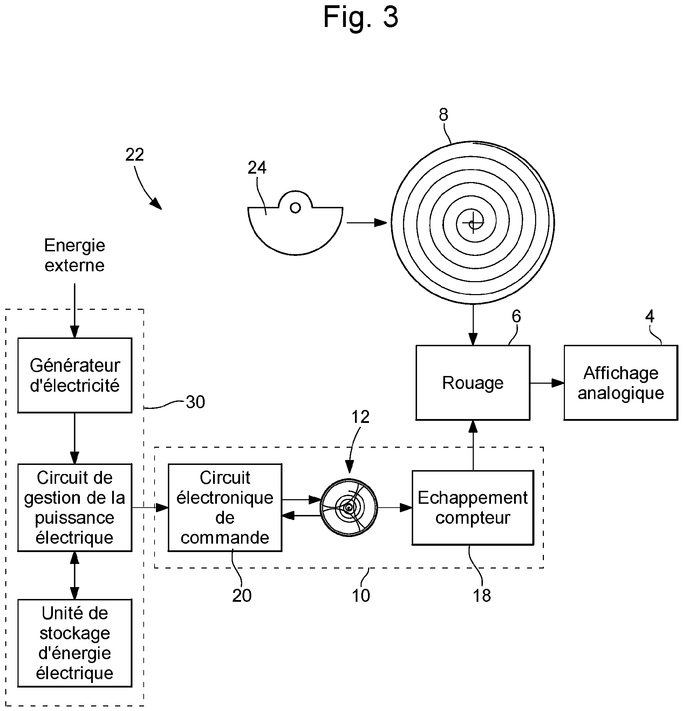

Le mouvement horloger 2 comprend un affichage analogique 4 de l'heure, un rouage 6, un barillet 8 entraînant l'affichage analogique via le rouage, et un oscillateur électromécanique 10 formé d'un résonateur 12, comprenant un balancier 14 et un spiral piézoélectrique 16, et d'un échappement mécanique 18A couplant le balancier au rouage. Le mouvement horloger est muni d'une masse oscillante 24 (non représentée aux Figures 1 et 2, mais à la Figure 3) servant à remonter le barillet. Le balancier est pivoté dans un pont de balancier 26, ce pont portant une raquetterie 28 servant au réglage de la fréquence d'oscillation du résonateur 12, comme ceci est usuel dans les mouvements horlogers du type mécanique.

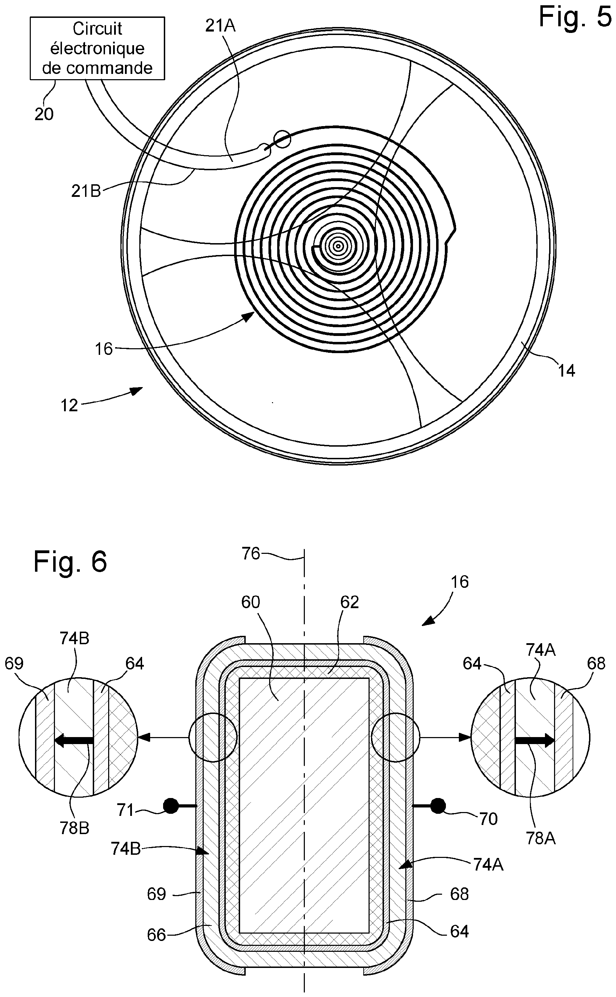

De manière générale, le spiral piézoélectrique est formé au moins partiellement d'un matériau piézoélectrique et comprend au moins deux électrodes dont au moins une électrode est reliée à un circuit électronique de commande 20. A la Figure 5 sont représentés le résonateur 12 et le circuit électronique de commande 20 auquel deux électrodes externes 68 et 69 du spiral piézoélectrique 16 sont reliés par deux liaisons électriques 21A et 21B. Une coupe transversale du spiral piézoélectrique 16 est représentée à la Figure 6 de manière nullement limitative. Ce spiral comprend un corps central 60 en silicium, une couche d'oxyde de silicium 62 déposée en surface du corps central de manière à compenser thermiquement le spiral, une première couche conductrice 64 déposée sur la couche d'oxyde de silicium, et un matériau piézoélectrique déposé sous forme d'une couche piézoélectrique 66 sur la première couche conductrice 64. Dans une variante particulière, la couche piézoélectrique est constituée d'un cristal de nitrure d'aluminium formé par une croissance de ce cristal depuis la première couche conductrice et perpendiculairement à celle-ci. Deux électrodes externes 68 et 69, formées par une deuxième couche conductrice partielle sur la couche piézoélectrique, sont agencées respectivement des deux côtés latéraux du spiral et sont reliées à deux bornes respectives 70 et 71 du circuit électronique de commande 20. Ainsi, la couche piézoélectrique 66 comprend une première partie 74A et une deuxième partie 74B qui s'étendent respectivement sur les deux côtés latéraux du corps central 60 et qui présentent, de par leur croissance depuis la première couche conductrice 64, des structures cristallographiques respectives qui sont symétriques relativement à un plan médian 76 parallèle à ces deux côtés latéraux. Ainsi, dans les deux parties latérales 74A et 74B, la couche piézoélectrique 66 présente deux axes piézoélectriques respectifs 78A et 78B perpendiculaires à cette couche piézoélectrique et de sens opposés.

Pour une même contrainte mécanique globale exercée sur le spiral piézoélectrique 16 (spiral en contraction ou en extension relativement à sa position de repos), une inversion du signe de la tension induite intervient entre l'électrode interne 64, formée par la première couche conductrice, et chacune des deux électrodes latérales externes 68 et 69 étant donné que, lorsque le spiral se contracte ou s'étend depuis sa position de repos, il y a une inversion de la contrainte mécanique dans les première et deuxième parties latérales 74A et 74B, c'est-à-dire que l'une de ces deux parties subit une compression alors que l'autre de ces parties subit une élongation / traction, et inversement.

Il résulte des considérations précédentes que des tensions induites locales dans les première et deuxième parties latérales 74A, 74B présentent, selon un axe géométrique perpendiculaire aux deux côtés latéraux, une même polarité, de sorte qu'une seule électrode interne commune 64 est suffisante, cette électrode interne commune s'étendant des deux côtés latéraux du corps central 60. On peut donc récupérer une tension induite entre les deux électrodes externes 68 et 69, laquelle correspond à l'addition des deux tensions induites locales (en valeurs absolues) qui sont générées respectivement dans les première et deuxième parties 74A et 74B de la couche piézoélectrique 66. Il résulte également de ces considérations qu'on peut appliquer une certaine tension entre les deux électrodes 68 et 69 pour contraindre activement le spiral lors d'une excitation du résonateur 12 et lors d'une alimentation électrique d'entretien d'une oscillation de ce résonateur. On remarquera que l'électrode interne, formée de la première couche conductrice 64, n'a pas besoin d'une liaison électrique propre avec le circuit électronique de commande 20 ou à la masse du mouvement horloger, bien que ceci ne soit pas exclu.

Dans le cadre de l'invention, le matériau piézoélectrique 66 et les deux électrodes 68 et 69 sont agencés de manière à permettre l'application, commandée par le circuit électronique de commande 20, d'une contrainte électrique sur le spiral piézoélectrique de manière à exciter l'oscillateur électromécanique 10, pour que le résonateur 12 se mette à osciller et obtenir une oscillation avec une amplitude fonctionnelle, et à ensuite entretenir cette oscillation fonctionnelle. A cet effet, le circuit électronique de commande 20 est relié à une source d'énergie électrique 30 permettant d'appliquer une tension électrique d'alimentation, entre les électrodes externes 68 et 69, dont la valeur est gérée par ce circuit électronique de commande. Plus généralement, le circuit électronique de commande 20 est agencé pour pouvoir commander l'application, au moins par moments, d'une tension électrique d'alimentation à au moins une des deux électrodes externes 68 et 69, de manière à exciter électriquement l'oscillateur électromécanique 10 pour obtenir une oscillation du résonateur avec une amplitude fonctionnelle, dite oscillation fonctionnelle, et à ensuite entretenir cette oscillation fonctionnelle. En particulier, il est prévu de fournir des impulsions motrices à l'oscillateur électromécanique 10, c'est-à-dire des impulsions d'énergie, qui permettent d'entretenir une oscillation fonctionnelle du résonateur 12. La fréquence de ces impulsions motrices dépend notamment de leur durée et de leur tension électrique. En particulier, de telles impulsions motrices peuvent être dimensionnées de manière qu'elles interviennent une fois lors de chaque alternance ou une fois par période de l'oscillation du résonateur.

L'échappement mécanique 18 est configuré de sorte à être un échappement compteur des alternances de l'oscillation fonctionnelle, pour pouvoir rythmer la marche du mouvement horloger, sans que le résonateur puisse recevoir du barillet via cet échappement une énergie mécanique suffisante à l'entretien de l'oscillation fonctionnelle. Pour qu'une oscillation soit fonctionnelle, il faut au moins qu'elle présente une amplitude suffisante pour permettre à l'ancre de l'échappement mécanique de faire des mouvements de va-et-vient (mouvement alternatif) entre deux positions de repos dans lesquelles le balancier formant le résonateur est libéré, c'est-à-dire non couplé mécaniquement à l'ancre.

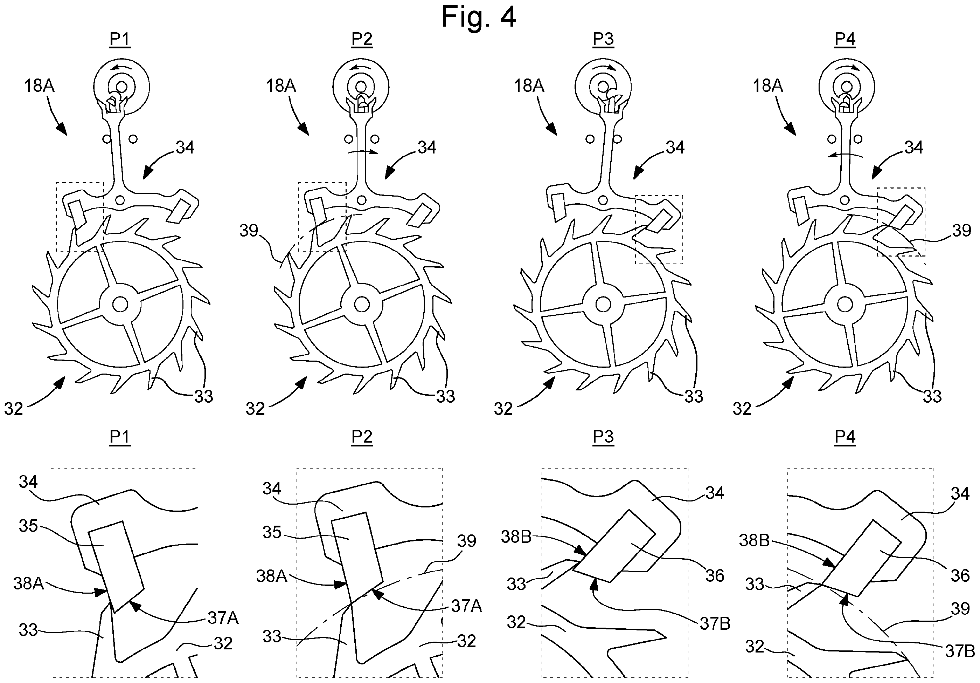

En référence à la Figure 4, on décrira un mode de réalisation d'un l'échappement 18A selon l'invention qui forme le dispositif de sortie de l'oscillateur électromécanique 10 (à noter que l'on peut considérer l'échappement compteur comme faisant partie de l'oscillateur ou comme étant associé à celui-ci). L'échappement 18A est un échappement du type à ancre suisse dont l'ancre 34 est modifiée de manière que ses deux palettes 35 et 36 présentent chacune, à leur extrémité libre prévue pour stopper momentanément une roue d'échappement 32, une surface d'extrémité 37A, respectivement 37B dont le point 'de contact' avec un cercle géométrique 39 circonscrit à la roue d'échappement, lorsque la palette considérée est dans une position angulaire correspondante (c'est-à-dire dans une position angulaire dans laquelle cette palette 'touche' le cercle géométrique circonscrit 39 sans le pénétrer), se situe à la jonction entre cette surface d'extrémité 37A, 37B et une surface latérale 38A, respectivement 38B de ladite palette considérée qui forme une butée pour les dents 33 de la roue d'échappement. Ainsi, l'échappement est configuré de sorte que, en fonctionnement normal, aucune dent 33 ne glisse le long des deux surfaces d'extrémité 37A, 37B des deux palettes respectives et ainsi aucune impulsion mécanique (aucun couple de force mécanique momentané) n'est fournie à l'ancre via ces deux surfaces d'extrémité, comme ceci est le cas dans un échappement à ancre suisse classique. Tout au plus ladite jonction (entre la surface d'extrémité et la surface latérale de chaque palette) peut glisser successivement, à chaque deux pas effectués par la roue d'échappement, sur l'extrémité de chaque dent de cette roue d'échappement et ainsi la roue d'échappement peut fournir à chaque pas une petite quantité d'énergie mécanique à l'ancre, laquelle est insuffisante pour pouvoir entretenir une oscillation fonctionnelle du résonateur 12. On remarquera que cette dernière variante n'est pas implémentée dans la variante représentée à la Figure 4, car le cercle géométrique circonscrit 39 est défini par les pointes des dents 33 qui viennent en appui contre les surfaces latérales 38A et 38B des palettes.

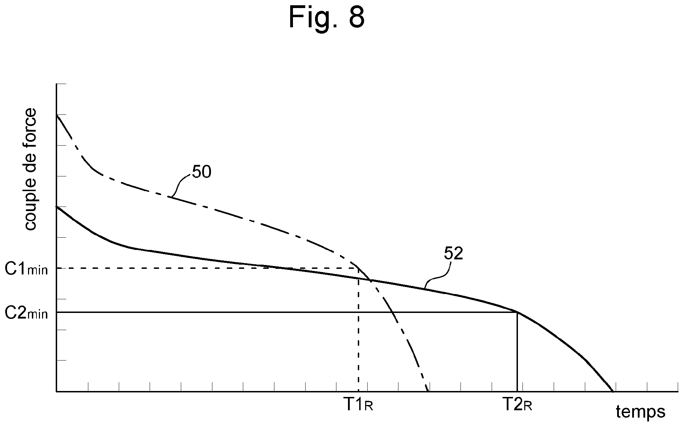

Grâce au concept de l'invention qui propose une alimentation électrique de l'oscillateur électromécanique, le barillet 8 ne doit pas alimenter cet oscillateur de sorte que la puissance mécanique que doit fournir le barillet est bien moindre que dans un mouvement mécanique classique dans lequel l'oscillateur consomme généralement une grande partie de l'énergie, notamment lorsque l'affichage se limite à un affichage de l'heure à deux ou trois aiguilles, éventuellement avec l'affichage analogique du quantième. De plus, le couple mécanique minimum nécessaire à l'entrainement du rouage et de l'affichage analogique est moindre que dans un mouvement mécanique classique où le barillet doit pouvoir exercer un couple de force sur l'ancre de manière à entretenir l'oscillation du résonateur mécanique. A la Figure 8 est représenté graphiquement le couple de force en fonction du temps pour un mouvement classique (courbe 50) et pour un mouvement horloger selon le premier mode de réalisation de l'invention (courbe 52) dans lequel le rapport de transmission entre le barillet et une roue des heures de l'affichage analogique a été augmenté, pour un même barillet, relativement à un mouvement mécanique correspondant (c'est-à-dire avec un échappement à ancre suisse classique et un balancier-spiral usuel). La quantité d'énergie dans le barillet reste la même, mais la réserve de marche est augmentée car le couple minimum C1ₘᵢₙ pour le mouvement mécanique classique est bien supérieur au couple minimum C2ₘᵢₙ pour le mouvement horloger 2 selon l'invention. On passe ainsi d'une réserve de marche T1_{R} à une réserve de marche T2_{R}, T2_{R} pouvant être par exemple deux à trois fois supérieure à T1_{R}. Dans une variante avantageuse, le rapport de transmission entre le barillet et la roue des heures de l'affichage analogique 4 est sensiblement égal ou supérieur à 6/5 (120%). Dans une variante préférée, ce rapport de transmission est sensiblement égal ou supérieur à 9/5 (180%).

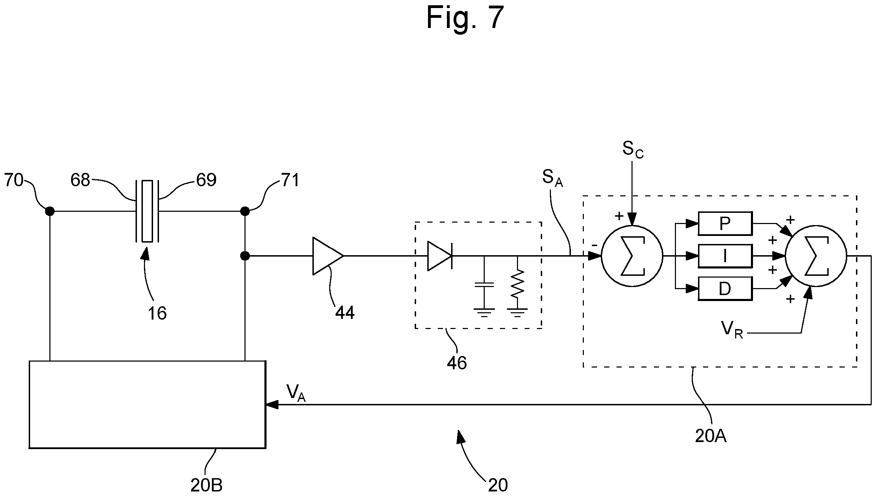

La Figure 7 montre une variante de réalisation préférée du circuit électronique de commande 20 qui est agencé pour pouvoir commander l'application d'une tension électrique d'alimentation à au moins une borne / électrode du spiral piézoélectrique de manière à maintenir l'amplitude de l'oscillation fonctionnelle du résonateur 12 / oscillateur 14 sensiblement constante, quelle que soit notamment l'orientation spatiale du mouvement horloger selon l'invention, en particulier de son résonateur 12. Le circuit électronique de commande comprend un détecteur de tension de crête 46, agencé pour pouvoir détecter sensiblement l'amplitude de la tension induite dans le spiral piézoélectrique 16 lorsque le résonateur 12 oscille, et un circuit de régulation 20A qui reçoit du détecteur de tension de crête un signal S_{A} relatif à l'amplitude de la tension induite et qui est agencé pour gérer une tension d'alimentation V_{A}, fournie au spiral piézoélectrique au travers d'une boucle à verrouillage de phase 20B, en fonction d'une valeur de consigne Sc pour le signal S_{A} fourni par le détecteur de tension de crête, de sorte à obtenir une oscillation du résonateur avec une amplitude sensiblement constante. La valeur de consigne Sc correspond à une amplitude de consigne prévue pour l'oscillation du résonateur 12. Le circuit de régulation 20A comprend des parties de traitement P, I, D agencées en parallèle et bien connues de la personne du métier, lesquelles traitent une différence entre la valeur de consigne Sc et la valeur du signal d'amplitude S_{A} par une réponse proportionnelle, respectivement en fonction d'une intégration et d'une dérivation de cette différence au cours du temps. Le circuit de régulation reçoit également une tension de référence V_{R} qui est ajustée en fonction de la régulation effectuée par le circuit 20A. Finalement, pour isoler le spiral piézoélectrique du détecteur de tension de crête et du circuit de régulation et éviter de perturber son alimentation électrique, un élément tampon 44 (transistor à haute impédance d'entrée) est prévu en amont du détecteur de tension de crête.

Dans un mode de réalisation principal, la boucle à verrouillage de phase 20B asservit la phase du signal d'alimentation périodique sur la phase du signal de tension induite, fournie notamment à la borne 71, pour que la tension d'alimentation contraigne le spiral piézoélectrique dans le sens de son mouvement, lequel est soit en contraction, soit en extension selon l'alternance en cours. Par exemple, le circuit 20B détecte les passages par zéro de la tension induite, notamment à la borne 71. Ainsi, pour que les impulsions soient motrices, la polarité de la tension d'alimentation est sélectionnée de manière à contraindre le spiral piézoélectrique dans le sens de son mouvement, lequel est alternativement en extension et en contraction au cours des alternances de l'oscillation du résonateur.

Dans un mode de réalisation particulier, un oscillateur à quartz est incorporé dans le circuit électronique de commande 20. Cet oscillateur à quartz peut être utilisé pour divers besoins. En particulier, la gestion de la tension d'alimentation V_{A} peut comprendre une modulation des impulsions motrices avec un rapport de cycle variable en fonction du signal d'amplitude S_{A} et de la valeur de consigne Sc, notamment de leur différence. Dans une variante avantageuse de ce mode de réalisation particulier, les impulsions motrices sont déclenchées avec une fréquence de consigne Fc pour l'oscillateur 10 / le résonateur 12 qui est déterminée de manière très précise par l'oscillateur à quartz. Si la fréquence Fs du signal d'alimentation n'est pas trop éloignée de la fréquence de résonance du résonateur, à savoir de sa fréquence naturelle F_{N}, du double de cette fréquence naturelle ou éventuellement d'une division entière de cette fréquence double, une telle alimentation du spiral piézoélectrique peut imposer la fréquence de consigne au résonateur 12 entretenu par lesdites impulsions motrices en assurant une amplitude suffisante pour une oscillation fonctionnelle, même pour une alimentation électrique gérée de manière à optimiser sa consommation, de sorte que l'oscillateur électromécanique 10 va pouvoir osciller à la fréquence de consigne, avec la précision du quartz, et une amplitude fonctionnelle quelle que soit l'orientation spatiale du mouvement horloger.

La variante avantageuse décrite ci-dessus peut être aisément implémentée pour obtenir un gain en précision pour la marche du mouvement horloger, et donc de la montre qui l'incorpore, quasi sans augmentation de la consommation électrique liée à l'entretien d'une oscillation fonctionnelle. On notera que, dans cette variante avantageuse, le circuit d'alimentation n'a pas besoin de comprendre une boucle à verrouillage de phase; ce qui simplifie son design.

En combinant la variante avantageuse susmentionnée avec la variante préférée du circuit électronique de commande qui a été décrite précédemment, on a une sorte de double régulation de la fréquence d'oscillation de l'oscillateur électromécanique, à savoir une première régulation en amplitude qui tend à maintenir constante l'amplitude d'oscillation, quelle que soit l'orientation spatiale du mouvement horloger, diminuant ainsi la variation de la fréquence naturelle du résonateur en lien avec l'orientation spatiale du mouvement horloger, de sorte que cette fréquence naturelle reste proche de la fréquence de consigne Fc pour toute orientation spatiale possible dès qu'un réglage initial est opéré correctement, et une seconde régulation obtenue par la génération des impulsions électriques motrices à la fréquence de consigne ou plus généralement avec des intervalles de temps entre les impulsions motrices dont la valeur D_{T} est égale à un nombre entier N multiplié par la moitié de la période de consigne Tc ( Tc = 1 / Fc ), soit une relation mathématique D_{T} = N·Tc / 2, N étant supérieur à zéro. Le nombre **N,** qui peut être variable, est prévu suffisamment petit pour assurer l'entretien d'une oscillation fonctionnelle et il est sélectionné dans une plage de valeurs permettant d'imposer la fréquence de consigne Fc à l'oscillateur électromécanique, cette plage de valeurs étant fonction de la plage de fréquences naturelles possibles pour cet oscillateur, laquelle est maintenue suffisamment proche de la fréquence de consigne grâce à la première régulation susmentionnée. Ainsi, comme la première régulation en amplitude permet de minimiser un écart maximal entre la fréquence naturelle F_{N} de l'oscillateur électromécanique et la fréquence de consigne, quelle que soit l'orientation du mouvement horloger, la seconde régulation par un signal d'alimentation périodique déterminé par l'oscillateur à quartz, en particulier par des impulsions motrices à la fréquence de consigne Fc, est garantie avec une amplitude fonctionnelle relativement grande, pour autant que le nombre N ne soit pas trop élevé. On a ainsi une précision de la marche du mouvement horloger qui est égale à celle de l'oscillateur à quartz pour toute orientation spatiale du mouvement horloger.

La variante avantageuse du mode de réalisation particulier peut, dans une autre implémentation, ne pas être combinée à la variante préférée du circuit électronique de commande, la régulation en amplitude n'étant pas prévue et la fréquence de l'oscillateur électromécanique étant imposée par la génération d'impulsions électriques motrices à une fréquence Fs = 2·Fc / N. Dans ce dernier cas, pour que la fréquence des impulsions électriques motrices puisse imposer la fréquence de consigne Fc à l'oscillateur électromécanique, ces impulsions électriques motrices sont de préférence dimensionnées pour que leur fréquence corresponde à un nombre N petit, par exemple N=1 ou N=2. A noter qu'un nombre N pair est préférable car la tension d'alimentation peut alors conserver une même polarité. Dans cette variante simplifiée, le circuit d'alimentation n'a pas besoin de comprendre une boucle à verrouillage de phase. Par contre, dans le mode de réalisation particulier, que ce soit la variante avantageuse ou la variante simplifiée qui soit implémentée, un oscillateur à quartz est incorporé au circuit électronique de commande du dispositif d'alimentation.

A noter que dans un autre mode de réalisation, un oscillateur à quartz est ajouté au circuit électronique de commande pour permettre une régulation de l'oscillation du balancier-spiral de manière que sa fréquence moyenne soit régulée et déterminée par une fréquence de référence générée par l'oscillateur à quartz.

La Figure 3 représente schématiquement une montre 22 selon l'invention comprenant un mouvement horloger selon l'invention. Les parties du mouvement horloger déjà décrites ne seront pas nouveau décrites ici en détails. La montre 22 comprend une source d'énergie électrique 30 qui est formée par un générateur d'électricité agencé pour produire de l'électricité de sorte à permettre une alimentation du circuit électronique de commande et du spiral piézoélectrique. Dans la variante représentée, le générateur d'électricité est relié à une unité de stockage, notamment une batterie rechargeable ou une super-capacité, via un circuit de gestion de la puissance électrique fournie au circuit électronique de commande 20 et à l'oscillateur électromécanique 10. En particulier, on notera que la tension nécessaire pour alimenter le spiral piézoélectrique est située dans une plage de tension entre 10 V et 40 V. Une telle tension est largement supérieure aux tensions de batterie incorporées généralement dans des montres et aussi bien supérieure aux tensions fournies par des cellules solaires du type horloger. Ainsi, le circuit de gestion de la puissance électrique est agencé pour pouvoir augmenter la tension accumulée dans l'unité de stockage ou fournie directement par le générateur d'électricité. A cet effet, il comprend un élévateur de tension, par exemple une pompe de charges.

Divers types de générateurs électriques peuvent être prévus, en particulier au moins une cellule solaire agencée au niveau du cadran de la montre ou de la lunette de cette montre. Dans une autre réalisation, il est prévu une thermopile qui reçoit comme énergie extérieure à la montre une énergie thermique provenant du bras de l'utilisateur. La thermopile est ainsi agencée de manière à pouvoir convertir de la chaleur du corps d'un utilisateur en électricité. Finalement, on notera que dans un autre mode de réalisation, la montre selon l'invention ne comprend pas de générateur électrique qui la rend autonome, mais elle comprend une batterie sous forme de pile usuelle.

## Revendications

1. Mouvement horloger (2) comprenant un affichage analogique (4) de l'heure, un rouage (6), un barillet (8) entraînant l'affichage analogique via le rouage, et un oscillateur (10) formé d'un résonateur (12), comprenant un balancier (14) et un spiral piézoélectrique (16), et d'un échappement mécanique (18 ; 18A) couplant le balancier au rouage, le spiral piézoélectrique étant formé au moins partiellement d'un matériau piézoélectrique (66) et comprenant au moins deux électrodes (68, 69) dont au moins une électrode est reliée à un circuit électronique de commande (20), le matériau piézoélectrique et ladite au moins une électrode étant agencés de manière à permettre l'application, gérée par le circuit électronique de commande, d'une contrainte électrique sur le spiral piézoélectrique ; le circuit électronique de commande étant agencé pour pouvoir être relié à une source d'énergie électrique (30) et pouvoir commander l'application, au moins par moments, d'une tension électrique d'alimentation à ladite au moins une électrode de manière à exciter l'oscillateur pour obtenir une oscillation fonctionnelle du résonateur et à ensuite entretenir cette oscillation fonctionnelle ; et où l'échappement mécanique (18 ; 18A) est configuré de sorte à être un échappement compteur des alternances de l'oscillation fonctionnelle, pour ainsi rythmer la marche du mouvement horloger, sans que le résonateur puisse recevoir du barillet via cet échappement mécanique une énergie mécanique qui soit suffisante à l'entretien de l'oscillation fonctionnelle.

2. Mouvement horloger selon la revendication 1, **caractérisé en ce que** le circuit électronique de commande (20) est agencé pour commander ladite application d'une tension électrique d'alimentation de manière à maintenir l'amplitude de l'oscillation fonctionnelle sensiblement constante.

3. Mouvement horloger selon la revendication 2, **caractérisé en ce que** le circuit électronique de commande (20) comprend un détecteur de tension de crête (46), lequel est agencé pour pouvoir détecter sensiblement l'amplitude d'une tension induite dans le spiral piézoélectrique (16) lorsque le résonateur (12) oscille, et un circuit de régulation (20A) qui reçoit du détecteur de tension de crête un signal (S_{A}) relatif à l'amplitude de la tension induite et qui est agencé pour pouvoir gérer une tension d'alimentation (V_{A}) en fonction d'une valeur de consigne (Sc) pour ledit signal (S_{A}) fourni par le détecteur de tension de crête, de sorte à obtenir une oscillation du résonateur avec une amplitude sensiblement constante.

4. Mouvement horloger selon une quelconque des revendications précédentes, **caractérisé en ce que** le rapport de transmission entre le barillet et une roue des heures dudit affichage analogique est égal ou supérieur à 6/5 (120%).

5. Mouvement horloger selon une quelconque des revendications précédentes, **caractérisé en ce que** le rapport de transmission entre le barillet et une roue des heures dudit affichage analogique est égal ou supérieur à 9/5 (180%).

6. Mouvement horloger selon une quelconque des revendications précédentes, **caractérisé en ce que** l'échappement mécanique est configuré de sorte à être un échappement uniquement compteur des alternances de l'oscillation fonctionnelle ; et **en ce que** le circuit électronique de commande est agencé pour pouvoir entretenir seul cette oscillation fonctionnelle.

7. Mouvement horloger selon la revendication 6, **caractérisé en ce que** l'échappement (18A) est un échappement du type à ancre suisse qui est modifié de manière que les deux palettes (34, 35) de l'ancre (34) présentent chacune, à leur extrémité libre prévue pour stopper momentanément une roue d'échappement (32), une surface d'extrémité (37A, 37B) dont le point de contact avec un cercle (39) circonscrit à la roue d'échappement, lorsque la palette considérée est dans une position angulaire correspondante, se situe à la jonction entre cette surface d'extrémité et une surface latérale (38A, 38B) de la palette considérée formant une butée pour les dents (33) de la roue d'échappement.

8. Mouvement horloger selon une quelconque des revendications précédentes, **caractérisé en ce qu'**il est muni d'une masse oscillante (24) pour remonter automatiquement le barillet (8).

9. Montre (22) comprenant un mouvement horloger (2) selon une quelconque des revendications précédentes, **caractérisée en ce que** la source d'énergie est incorporée dans cette montre et comprend un générateur d'électricité agencé pour produire de l'électricité de sorte à permettre une alimentation du circuit électronique de commande (20) et du spiral piézoélectrique (16).

10. Montre selon la revendication 9, **caractérisée en ce que** le générateur d'électricité comprend un capteur de lumière

11. Montre selon la revendication 9, **caractérisée en ce que** le générateur d'électricité comprend une thermopile agencée de manière à pouvoir convertir de la chaleur du corps d'un utilisateur en électricité.

## Patentansprüche

1. Uhrwerk (2), das eine analoge Zeitanzeige (4), ein Räderwerk (6), ein Federhaus (8), das die analoge Anzeige über das Räderwerk antreibt, und einen Oszillator (10), der aus einem Resonator (12), der eine Unruh (14) und eine piezoelektrische Spirale (16) umfasst, und aus einer mechanischen Hemmung (18; 18A) gebildet wird, welche die Unruh mit dem Räderwerk koppelt, umfasst, wobei die piezoelektrische Spirale zumindest teilweise aus einem piezoelektrischen Werkstoff (66) gebildet ist und mindestens zwei Elektroden (68, 69) umfasst, von denen mindestens eine Elektrode mit einer elektronischen Steuerschaltung (20) verbunden ist, wobei der piezoelektrische Werkstoff und die mindestens eine Elektrode angeordnet sind, um das von der elektronischen Steuerschaltung verwaltete Anlegen einer elektrischen Spannung an die piezoelektrische Spirale zu ermöglichen; wobei die elektronische Steuerschaltung angeordnet ist, um mit einer elektrischen Energiequelle (30) verbunden werden zu können, und um das zumindest zeitweise Anlegen einer elektrischen Versorgungsspannung an die mindestens eine Elektrode steuern zu können, um den Oszillator anzuregen, um eine funktionelle Schwingung des Resonators zu erhalten, und um diese funktionelle Schwingung danach aufrechtzuerhalten; und wobei die mechanische Hemmung (18; 18A) konfiguriert ist, um eine Zählerhemmung für die Halbschwingungen der funktionellen Schwingung zu sein, um so den Rhythmus des Ganges des Uhrwerks zu bestimmen, ohne dass der Resonator vom Federhaus über diese mechanische Hemmung eine mechanische Energie erhalten kann, die zur Aufrechterhaltung der funktionellen Schwingung ausreicht.

2. Uhrwerk nach Anspruch 1, **dadurch gekennzeichnet, dass** die elektronische Steuerschaltung (20) angeordnet ist, um das Anlegen einer elektrischen Versorgungsspannung zu steuern, um die Amplitude der funktionellen Schwingung im Wesentlichen konstant zu halten.

3. Uhrwerk nach Anspruch 2, **dadurch gekennzeichnet, dass** die elektronische Steuerschaltung (20) einen Spitzenspannungsdetektor (46) umfasst, der angeordnet ist, um die Amplitude einer in der piezoelektrischen Spirale (16) induzierten Spannung im Wesentlichen detektieren zu können, wenn der Resonator (12) oszilliert, und eine Regelschaltung (20A), die von dem Spitzenspannungsdetektor ein Signal (S_{A}) in Bezug auf die Amplitude der induzierten Spannung empfängt, und die angeordnet ist, um eine Versorgungsspannung (V_{A}) in Abhängigkeit von einem Sollwert (Sc) für das Signal (S_{A}), das von dem Spitzenspannungsdetektor geliefert wird, verwalten zu können, um eine Schwingung des Resonators mit einer im Wesentlichen konstanten Amplitude zu erhalten.

4. Uhrwerk nach einem der vorstehenden Ansprüche, **dadurch gekennzeichnet, dass** das Übersetzungsverhältnis zwischen dem Federhaus und einem Stundenrad der analogen Anzeige gleich oder größer als 6/5 (120 %) ist.

5. Uhrwerk nach einem der vorstehenden Ansprüche, **dadurch gekennzeichnet, dass** das Übersetzungsverhältnis zwischen dem Federhaus und einem Stundenrad der analogen Anzeige gleich oder größer als 9/5 (180 %) ist.

6. Uhrwerk nach einem der vorstehenden Ansprüche, **dadurch gekennzeichnet, dass** die mechanische Hemmung konfiguriert ist, um eine Hemmung nur zum Zählen der Halbschwingungen der funktionellen Schwingung zu sein; und dadurch, dass die elektronische Steuerschaltung angeordnet ist, um allein diese funktionelle Schwingung aufrechterhalten zu können.

7. Uhrwerk nach Anspruch 6, **dadurch gekennzeichnet, dass** die Hemmung (18A) eine Hemmung vom Typ Schweizer Anker ist, die modifiziert ist, sodass die beiden Paletten (34, 35) des Ankers (34) jeweils an ihrem freien Ende, das dazu vorgesehen ist, ein Hemmungsrad (32) vorübergehend zu stoppen, eine Endoberfläche (37A, 37B) aufweisen, deren Berührungspunkt mit einem Kreis (39), der das Hemmungsrad umschreibt, wenn sich die betreffende Palette in einer entsprechenden Winkelposition befindet, an der Verbindung zwischen dieser Endoberfläche und einer Seitenoberfläche (38A, 38B) der betreffenden Palette liegt, die einen Anschlag für die Zähne (33) des Hemmungsrades bildet.

8. Uhrwerk nach einem der vorstehenden Ansprüche, **dadurch gekennzeichnet, dass** es mit einer Schwungmasse (24) zum automatischen Aufziehen des Federhauses (8) versehen ist.

9. Uhr (22), die ein Uhrwerk (2) nach einem der vorstehenden Ansprüche umfasst, **dadurch gekennzeichnet, dass** die Energiequelle in dieser Uhr verbaut ist und einen Stromgenerator umfasst, der angeordnet ist, um Strom zu erzeugen, um eine Versorgung der elektronischen Steuerschaltung (20) und der piezoelektrischen Spiralfeder (16) zu ermöglichen.

10. Uhr nach Anspruch 9, **dadurch gekennzeichnet, dass** der Stromgenerator einen Lichtsensor umfasst.

11. Uhr nach Anspruch 9, **dadurch gekennzeichnet, dass** der Stromgenerator eine Thermosäule umfasst, die angeordnet ist, um die Wärme eines Körpers eines Benutzers in Strom umwandeln zu können.

## Claims

1. A horological movement (2) comprising an analogue time display (4), a gear train (6), a barrel (8) driving the analogue display via the gear train, and an oscillator (10) formed of a resonator (12), comprising a balance (14) and a piezoelectric spring (16), and a mechanical escapement (18; 18A) coupling the balance to the gear train, the piezoelectric spring being formed at least partially of a piezoelectric material (66) and comprising at least two electrodes (68, 69) at least one electrode of which is connected to an electronic control circuit (20), the piezoelectric material and said at least one electrode being arranged so as to allow the application, managed by the electronic control circuit, of an electrical stress on the piezoelectric spring; the electronic control circuit being arranged to be able to be connected to an electric energy source (30) and to be able to control the application, at least occasionally, of a power supply voltage to said at least one electrode so as to excite the oscillator to obtain a functional oscillation of the resonator and then to maintain this functional oscillation; wherein the mechanical escapement (18; 18A) is configured so as to be an escapement for counting the alternations of the functional oscillation, thus in order to pace the running of the horological movement, without the resonator being able to receive from the barrel via this mechanical escapement enough mechanical energy to maintain the functional oscillation.

2. The horological movement according to claim 1, **characterised in that** the electronic control circuit (20) is arranged to control said application of an electrical supply voltage so as to maintain the amplitude of the functional oscillation substantially constant.

3. The horological movement according to claim 2, **characterised in that** the electronic control circuit (20) comprises a peak voltage detector (46), which is arranged to be able to substantially detect the amplitude of a voltage induced in the piezoelectric spring (16) when the resonator (12) oscillates, and a regulation circuit (20A) which receives from the peak voltage detector a signal (S_{A}) relating to the amplitude of the induced voltage and which is arranged to be able to manage a power supply voltage (V_{A}) according to a setpoint value (Sc) for said signal (S_{A}) supplied by the peak voltage detector, so as to obtain an oscillation of the resonator with a substantially constant amplitude.

4. The horological movement according to any one of the preceding claims, **characterised in that** the transmission ratio between the barrel and an hour wheel of said analogue display is equal to or greater than 6/5 (120%).

5. The horological movement according to any one of the preceding claims, **characterised in that** the transmission ratio between the barrel and an hour wheel of said analogue display is equal to or greater than 9/5 (180%).

6. The horological movement according to any one of the preceding claims, **characterised in that** the mechanical escapement is configured so as to be an escapement only for counting the alternations of the functional oscillation; and **in that** the electronic control circuit is arranged to be able to maintain this functional oscillation alone.

7. The horological movement according to claim 6, **characterised in that** the escapement (18A) is a Swiss lever type escapement which is modified so that the two pallets (34, 35) of the lever (34) each have, at their free end intended to momentarily stop an escape wheel (32), an end surface (37A, 37B) whose point of contact with a circle (39) circumscribed to the escape wheel, when the pallet in question is in a corresponding angular position, is located at the junction between this end surface and a lateral surface (38A, 38B) of the pallet in question forming a stop for the teeth (33) of the escape wheel.

8. The horological movement according to any one of the preceding claims, **characterised in that** it is provided with an oscillating mass (24) to automatically wind the barrel (8).

9. A watch (22) comprising a horological movement (2) according to any one of the preceding claims, **characterised in that** the energy source is incorporated in this watch and comprises an electricity generator arranged to produce electricity so as to allow the electronic control circuit (20) and the piezoelectric spring (16) to be power supplied.

10. The watch according to claim 9, **characterised in that** the electricity generator comprises a light sensor

11. The watch according to claim 9, **characterised in that** the electricity generator comprises a thermopile arranged so as to be able to convert heat from the body of a user into electricity.
